# EUROPEAN PATENT APPLICATION

(11) **EP 4 757 520 A1**
(43) Date of publication of application: **10.06.2026**
(21) Application number: 25182877.8
(22) Date of filing: 16.06.2025
(51) Int. Cl.: H10B 12/00

(54) **CAPACITOR-LESS STACKED DRAM CELL BASED ON VERTICAL TRANSISTOR**

(30) Priority: 06.12.2024 KR 20240180232
(71) Applicant: UIF (University Industry Foundation), Yonsei University, Seoul 03722 (KR)
(72) Inventor: KIM, Hyun Jae, 04094 Seoul (KR); KWAK, Kyungmoon, 02807 Seoul (KR); AN, Jong Bin, 06006 Seoul (KR); CHUNG, Jusung, 03721 Seoul (KR); CHOI, Dong Hyun, 03783 Seoul (KR); AHN, Jong Hyuk, 05272 Seoul (KR); LEE, Moon Ho, 03787 Seoul (KR); LEE, Ju Hyun, 03024 Seoul (KR); HONG, Seok Min, 03726 Seoul (KR)
(74) Representative: Jung, Minkyu

(57) **Abstract**

A capacitor-less stacked DRAM cell based on a vertical transistor includes a first vertical transistor and a second vertical transistor, and each of the first vertical transistor and the second vertical transistor includes a spacer, a source disposed on an upper surface of the spacer, a drain disposed adjacent to a lower portion of a side surface of the spacer, a channel disposed along an upper surface of the drain, an upper portion of the side surface of the spacer, and an upper surface of the source, a gate insulator disposed along a side surface and an upper surface of the channel, and a gate electrode disposed along a side surface and an upper surface of the gate insulator.

## Description

### CROSS-REFERENCE TO RELATED APPLICATIONS

This application claims priority under 35 U.S.C. § 119 to Korean Patent Application No. 10-2024-0180232 filed on December 06, 2024, in the Korean Intellectual Property Office, the disclosures of which are incorporated by reference herein in their entireties.

### BACKGROUND

Embodiments of the present disclosure described herein relate to a capacitor-less stacked DRAM cell based on a vertical transistor.

The present disclosure is derived from the research conducted as part of the key technology development of the National Semiconductor Laboratory (NSL) of the Ministry of Science and ICT (Project Identification Number: 1711197801, Project Number: 00256917, Research Project Title: Development of IGZO V-Tr based high-integration/high-performance capacitor-less DRAM technology for next-generation neuromorphic computing systems, Project Management Organization: National Research Foundation of Korea, Project Executing Organization: Yonsei University Industry-Academic Cooperation Foundation, Research Period: 2023.05.01 ~ 2024.01.31). Meanwhile, the Korean government has no property interest in all aspects of the present disclosure.

3D DRAM refers to DRAM having a structure in which flat DRAM cells are stacked in the z-axis direction. Accordingly, it is essential to form a channel material as a thin film for each stacked layer on a single-crystalline silicon substrate used in an existing 1 transistor-1 capacitor structure. However, in the 1 transistor-1 capacitor DRAM in the related art, there is a limitation in improving the degree of integration due to a collision between cells and leakage current.

### SUMMARY

Embodiments of the present disclosure provide a capacitor-less stacked DRAM cell based on a vertical transistor for improving a degree of integration by reducing a collision between cells and leakage current.

Embodiments of the present disclosure provide a capacitor-less stacked DRAM cell based on a vertical transistor for improving the electrical performance of a transistor by minimizing an overlap area that inevitably occurs in a vertical structure transistor.

According to an embodiment, a capacitor-less stacked DRAM cell based on a vertical transistor includes a first vertical transistor and a second vertical transistor, and each of the first vertical transistor and the second vertical transistor includes a spacer, a source disposed on an upper surface of the spacer, a drain disposed adjacent to a lower portion of a side surface of the spacer, a channel disposed along an upper surface of the drain, an upper portion of the side surface of the spacer, and an upper surface of the source, a gate insulator disposed along a side surface and an upper surface of the channel, and a gate electrode disposed along a side surface and an upper surface of the gate insulator.

The first vertical transistor and the second vertical transistor may be disposed to face each other.

A write word line may be connected to the gate electrode of the first vertical transistor, a write bit line may be connected to the source of the first vertical transistor, a read word line may be connected to the source of the second vertical transistor, and a read bit line may be connected to the drain of the second vertical transistor.

A storage node may be disposed between the drain of the first vertical transistor and the gate electrode of the second vertical transistor.

Each of the spacer of the first vertical transistor and the spacer of the second vertical transistor may be deposited through ALD or PVD.

Each of the channel of the first vertical transistor and the channel of the second vertical transistor may include an oxide semiconductor.

A first source being the source of the first vertical transistor and a second source being the source of the second vertical transistor may be disposed on the upper surfaces of the spacers of the first vertical transistor and the second vertical transistor such that lower surfaces of the first source and the second source are disposed in positions not facing an upper surface of a first drain being the drain of the first vertical transistor and an upper surface of a second drain being the drain of the second vertical transistor.

The first vertical transistor may include a first spacer, a first source disposed on an upper surface of the first spacer, a first drain disposed adjacent to a lower portion of a side surface of the first spacer, and a first channel disposed along an upper surface of the first drain, an upper portion of the side surface of the first spacer, and an upper surface of the first source, and the second vertical transistor may include a second spacer, a second source disposed on an upper surface of the second spacer, a second drain disposed adjacent to a lower portion of a side surface of the second spacer, and a second channel disposed along an upper surface of the second drain, an upper portion of the side surface of the second spacer, and an upper surface of the second source.

The first drain and the second drain may be disposed at the same height with respect to a ground, the second spacer may be configured such that the upper surface thereof is located in a higher position with respect to the ground than the upper surface of the first spacer, and the second source may be disposed in a higher position with respect to the ground than the first source.

The first vertical transistor may further include a first gate insulator disposed along a side surface and an upper surface of the first channel and a first gate electrode disposed along a side surface and an upper surface of the first gate insulator, and the second vertical transistor may further include a second gate insulator disposed along a side surface and an upper surface of the second channel and a second gate electrode disposed along a side surface and an upper surface of the second gate insulator.

According to an embodiment, a method for manufacturing the capacitor-less stacked DRAM cell based on the vertical transistor includes a step of forming the first spacer through dry etching, a step of forming the second spacer through dry etching, a step of depositing the first drain on the lower portion of the side surface of the first spacer, a step of depositing the second drain on the lower portion of the side surface of the second spacer, a step of depositing the first source on the upper surface of the first spacer, a step of depositing the second source on the upper surface of the second spacer, a step of depositing the first channel along the upper portion of the side surface of the first spacer and the upper surface of the first source, and a step of depositing the second channel along the upper portion of the side surface of the second spacer and the upper surface of the second source.

The step of depositing the first drain on the lower portion of the side surface of the first spacer may include a step of depositing the first drain on the lower portion of the side surface of the first spacer that faces the side surface of the second spacer, and the step of depositing the second drain on the lower portion of the side surface of the second spacer may include a step of depositing the second drain on the lower portion of the side surface of the second spacer that faces the side surface of the first spacer.

The step of forming the second spacer through the dry etching may include a step of forming the second spacer such that the upper surface of the second spacer is located in a higher position with respect to a ground than the upper surface of the first spacer, and the step of depositing the second source on the upper surface of the second spacer may include a step of depositing the second source such that the second source is disposed in a higher position with respect to the ground than the first source.

The step of depositing the first channel may include a step of depositing the first channel along the upper surface of the first source and the upper portion of the side surface of the first spacer that faces the side surface of the second spacer, and the step of depositing the second channel may include a step of depositing the second channel along the upper surface of the second source and the upper portion of the side surface of the second spacer that faces the side surface of the first spacer.

### BRIEF DESCRIPTION OF THE FIGURES

The above and other objects and features will become apparent from the following description with reference to the following figures, wherein like reference numerals refer to like parts throughout the various figures unless otherwise specified, and wherein:
FIG. 1 is a perspective view of a capacitor-less stacked DRAM cell based on a vertical transistor according to an embodiment of the present disclosure;
FIG. 2 is a schematic diagram illustrating a process of manufacturing a capacitor-less stacked DRAM cell based on a vertical transistor according to an embodiment of the present disclosure;
FIG. 3 is a side view illustrating an example that a DRAM cell based on a vertical transistor is stacked in two layers according to an embodiment of the present disclosure; and
FIG. 4 is a circuit diagram illustrating a DRAM cell based on a vertical transistor according to an embodiment of the present disclosure.

### DETAILED DESCRIPTION

Hereinafter, specific details for carrying out the present disclosure will be described in detail with reference to the accompanying drawings. However, detailed descriptions related to well-known functions or configurations will be omitted when they may make subject matters of the present disclosure unnecessarily obscure.

In the accompanying drawings, identical or corresponding components will be assigned with identical reference numerals. Furthermore, in the following description of embodiments, repetitive descriptions of the identical or corresponding components may be omitted. However, the omission of the descriptions of the components does not intend that the components are not included in certain embodiments.

Aspects, features, and advantages of the present disclosure will become apparent from the following description of embodiments given in conjunction with the accompanying drawings. However, the present disclosure is not limited to the embodiments disclosed herein and may be implemented in various different forms. Herein, the embodiments are provided to provide complete disclosure of the present disclosure and to provide thorough understanding of the present disclosure to those skilled in the art to.

The terminology used herein will be described briefly, and the present disclosure will be described in detail. The terminology used herein is defined in consideration of the function of corresponding components used in the present disclosure and may be varied according to users, operator's intention, or practices. In addition, an arbitrary defined terminology may be used in a specific case and will be described in detail in a corresponding description paragraph. Therefore, the terminology used herein is for the purpose of describing particular embodiments only and is not intended to be limiting of the present disclosure.

The terms of a singular form may include plural forms unless otherwise specified. In addition, the terms of a plural form may include singular forms unless otherwise specified. In this specification, when a portion "includes" a component, it may mean that the portion does not exclude another component unless specifically described to the contrary, but may further include another component.

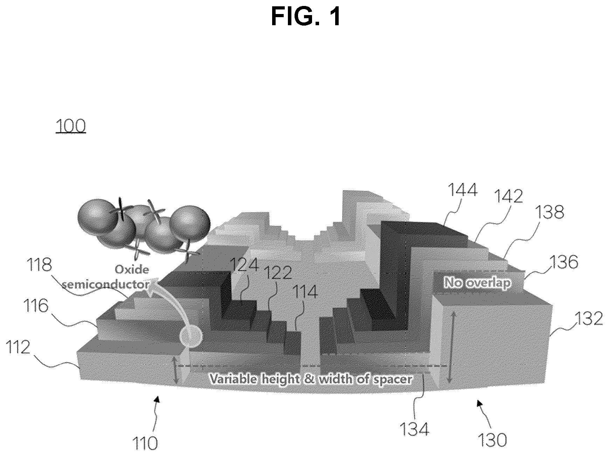

FIG. 1 is a perspective view of a capacitor-less stacked DRAM cell 100 based on a vertical transistor according to an embodiment of the present disclosure.

Referring to FIG. 1, the DRAM cell 100 may include a first vertical transistor 110 and a second vertical transistor 130.

The first vertical transistor 110 may include a first spacer 112, a first drain 114, a first source 116, a first channel 118, a first gate insulator 122, and a first gate electrode 124.

The second vertical transistor 130 may include a second spacer 132, a second drain 134, a second source 136, a second channel 138, a second gate insulator 142, and a second gate electrode 144.

Each of the first channel 118 and the second channel 138 may include an oxide semiconductor.

The oxide semiconductor may include at least one of InO, SnO, ZnO, InZnO, SnZnO, InSnO, SnMgO, InMgO, AlZnO, ZnMgO, InSnZnO, SnGaZnO, AlGaZnO, SnAlZnO, InAlZnO, InGaZnO, or InSnGaZnO, but is not limited thereto.

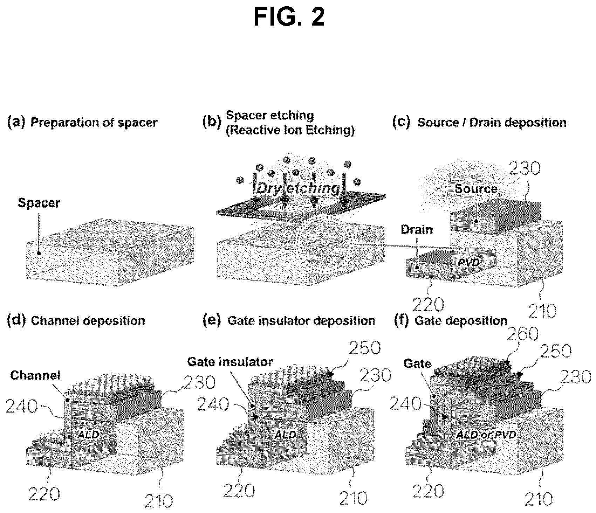

Meanwhile, in FIGS. 1 and 2, for convenience, description of the structure of the vertical transistor is disclosed based on the first vertical transistor 110. That is, in FIGS. 1 and 2, the description of the first vertical transistor 110 may be interpreted as being replaced with the second vertical transistor 130 and structures thereof.

The first vertical transistor 110 may include the first spacer 112 provided on a substrate. Additionally, the first vertical transistor 110 may include the first source 116 disposed on an upper surface of the first spacer 112. In addition, the first vertical transistor 110 may include the first drain 114 disposed adjacent to a lower portion of a side surface of the first spacer 112. Due to the above-described configuration, the first vertical transistor 110 may be designed such that there is no overlap area between the first drain 114 and the first source 116 when the first vertical transistor 110 is observed from above.

The first vertical transistor 110 may include the channel 118 disposed in the shape of "z" along an upper surface of the first drain 114, an upper portion of the side surface of the first spacer 112, and an upper surface of the first source 116. Additionally, the first vertical transistor 110 may include the first gate insulator 122 disposed in the shape of "z" along a side surface and an upper surface of the first channel 118. Similarly, the first vertical transistor 110 may include the first gate electrode 124 disposed in the shape of "z" along a side surface and an upper surface of the first gate insulator 122.

Meanwhile, the first vertical transistor 110 and the second vertical transistor 130 that have the above-described structure may be disposed to face each other.

Meanwhile, due to the characteristics of the DRAM cell 100, it may be desirable that the channel of the second vertical transistor 130 is wider than the channel of the first vertical transistor 110.

The first drain 114 and the second drain 134 may be disposed at the same height with respect to the ground.

The second spacer 132 may be configured such that an upper surface thereof is located in a higher position than the upper surface 112 of the first spacer 112.

The second source 136 may be disposed in a higher position with respect to the ground than the first source 116.

FIG. 2 is a schematic diagram illustrating a process of manufacturing a capacitor-less stacked DRAM cell (e.g., the DRAM cell 100) based on a vertical transistor according to an embodiment of the present disclosure.

In FIG. 2, a spacer 210, a drain 220, a source 230, a channel 240, a gate insulator 250, and a gate electrode 260 may correspond to the first spacer 112, the first drain 114, the first source 116, the first channel 118, the first gate insulator 112, and the first gate electrode 124 of FIG. 1, respectively.

Additionally, in FIG. 2, the spacer 210, the drain 220, the source 230, the channel 240, the gate insulator 250, and the gate electrode 260 may correspond to the second spacer 132, the second drain 134, the second source 136, the second channel 138, the second gate insulator 142, and the second gate electrode 144, respectively.

Referring to FIGS. 2 (a) and 2 (c), the spacer 210 for the DRAM cell may be formed through dry etching, and the drain 220 and the source 230 may be deposited on a lower portion of a side surface and an upper surface of the spacer 210, respectively.

Referring to FIGS. 2 (d) to 2(f), the channel 240 having the shape of "z" may be deposited along an upper surface of the drain 220, an upper portion of the side surface of the spacer 210, and an upper surface of the source 230. Likewise, the gate insulator 250 and the gate electrode 260 may be deposited in the shape of "z".

A method for manufacturing the capacitor-less stacked DRAM cell 100 based on the vertical transistor may include a step of forming the first spacer 112 through dry etching, a step of forming the second spacer 132 through dry etching, a step of depositing the first drain 114 on the lower portion of the side surface of the first spacer 112, a step of depositing the second drain 134 on the lower portion of the side surface of the second spacer 132, a step of depositing the first source 116 on the upper surface of the first spacer 112, a step of depositing the second source 136 on the upper surface of the second spacer 132, a step of depositing the first channel 118 along the upper portion of the side surface of the first spacer 112 and the upper surface of the first source 116, and a step of depositing the second channel 138 along the upper portion of the side surface of the second spacer 132 and the upper surface of the second source 136.

The step of depositing the first drain 114 on the lower portion of the side surface of the first spacer 112 may be a step of depositing the first drain 114 on the lower portion of the side surface of the first spacer 112 that faces the side surface of the second spacer 132.

The step of depositing the second drain 134 on the lower portion of the side surface of the second spacer 132 may be a step of depositing the second drain 134 on the lower portion of the side surface of the second spacer 132 that faces the side surface of the first spacer 112.

The step of forming the second spacer 132 through the dry etching may be a step of forming the second spacer 132 such that the upper surface of the second spacer 132 is located in a higher position with respect to the ground than the upper surface of the first spacer 112.

The step of depositing the second source 136 on the upper surface of the second spacer 132 may be a step of depositing the second source 136 such that the second source 136 is disposed in a higher position with respect to the ground than the first source 116.

The step of depositing the first channel 118 may be a step of depositing the first channel 118 along the upper surface of the first source 116 and the upper portion of the side surface of the first spacer 112 that faces the side surface of the second spacer 132.

The step of depositing the second channel 138 may be a step of depositing the second channel 138 along the upper surface of the second source 136 and the upper portion of the side surface of the second spacer 132 that faces the side surface of the first spacer 112.

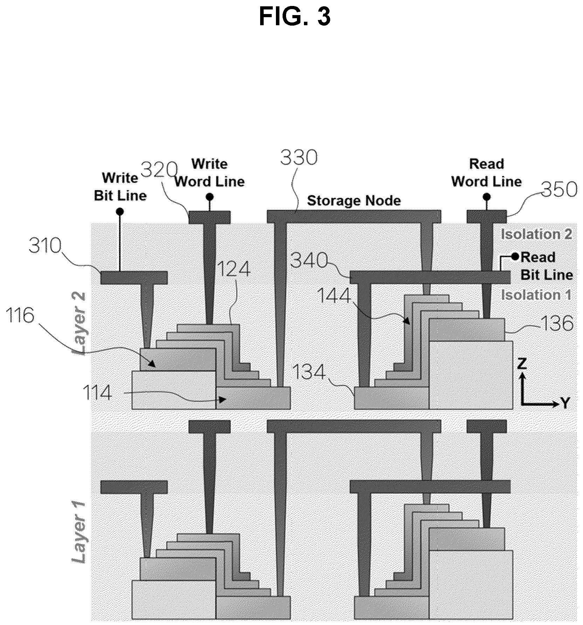

Meanwhile, in the vertical transistor, the width (that is, the horizontal length) and the height (that is, the vertical length) of the side surface of the spacer 210 may be freely modified. In addition, when the vertical transistor is observed from above, the vertical transistor may be designed such that there is no overlap area between the drain 220 and the source 230. Accordingly, when the corresponding transistor is a read transistor, the value of oxidation capacitance may be easily adjusted. In addition, it may be easy to lower a leakage current value of a write transistor to prevent charge leakage at a storage node 330 (to be described below with reference to FIG. 3). This may lead to an increase in retention time.

Specifically, the first source 116 may be disposed on the upper surface of the first spacer 112 such that the lower surface of the first source 116 is disposed in a position that does not face the upper surface of the first drain 114.

The second source 136 may be disposed on the upper surface of the second spacer 132 such that the lower surface of the second source 136 is disposed in a position that does not face the upper surface of the second drain 134.

That is, since there is no overlap area between the drain 220 and the source 230 when the vertical transistor is observed from above, the DRAM cell 100 based on the vertical transistor according to an embodiment may minimize an overlap area that inevitably occurs in a vertical structure transistor, thereby improving the electrical performance of the transistor.

A device having a vertical structure in the related art has a problem in that an overlap area (OA) is inevitably widened and therefore an electric field in the z-axis direction that is applied to a channel increases. That is, the device having the vertical structure in the related art has a problem in that a normal accumulation layer cannot be formed in the channel, whereas in the case of the DRAM cell 100 based on the vertical transistor that is manufactured through the manufacturing process according to the embodiment, due to its structure, an overlap area (OA) may be eliminated, and thus a phenomena such as an increase in subthreshold swing (S.S.) caused by the overlap area (OA) may not occur.

FIG. 3 is a side view illustrating an example that a DRAM cell (e.g., the DRAM cell 100) based on a vertical transistor is stacked in two layers according to an embodiment of the present disclosure. As illustrated, a write bit line 310 may be connected to the first source 116, and a write word line 320 may be connected to the first gate electrode 124. Similarly, a read word line 350 may be connected to the second source 136, and a read bit line 340 may be connected to the second drain 134. Additionally, the storage node 330 may be disposed between the first drain 114 and the second gate electrode 144.

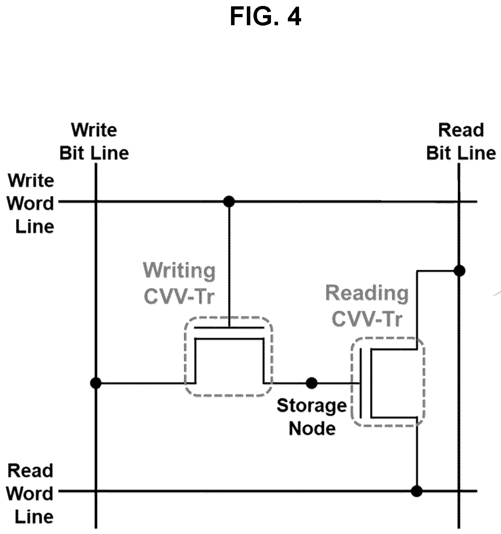

FIG. 4 is a circuit diagram illustrating a DRAM cell (e.g., the DRAM cell 100) based on a vertical transistor according to an embodiment of the present disclosure. Each of a "writing CVV-Tr" and a "reading CVV-Tr" may correspond to one of a first vertical transistor (e.g., the first vertical transistor 110) and a second vertical transistor (e.g., the second vertical transistor 130). That is, when the first vertical transistor 110 is the "writing CVV-Tr", the second vertical transistor 130 may be the "reading CVV-Tr", and when the first vertical transistor 110 is the "reading CVV-Tr", the second vertical transistor 130 may be the "writing CVV-Tr". Referring to FIG. 4, since the source of the writing CVV-Tr is connected to the gate of the reading CVV-Tr and operates and the two transistors share a partial area without a capacitor, a high degree of integration may be achieved.

According to some embodiments of the present disclosure, when a transistor is a read transistor, the value of oxidation capacitance may be easily adjusted.

According to some embodiments of the present disclosure, it may be easy to lower a leakage current value of a write transistor to prevent charge leakage at a storage node.

According to some embodiments of the present disclosure, an increase in retention time may be achieved.

According to some embodiments of the present disclosure, since two transistors share a partial area without a capacitor, a high degree of integration may be achieved.

According to some embodiments of the present disclosure, the electrical performance of a transistor may be improved by minimizing an overlap area that inevitably occurs in a vertical structure transistor.

The above description of the present disclosure is provided to enable those skilled in the art to perform or use the present disclosure. Various modifications of the present disclosure will be obvious to those skilled in the art, and the general principles defined herein may be applied to various modifications without departing from the spirit or scope of the present disclosure. Accordingly, the present disclosure is not intended to be limited to the examples set forth herein but is intended to be accorded the widest scope consistent with the principles and novel features disclosed herein.

Although example implementations may refer to utilizing aspects of the presently disclosed subject matter in the context of one or more standalone computer systems, the subject matter is not so limited, and they may be implemented in conjunction with any computing environment, such as a network or distributed computing environment. Furthermore, aspects of the presently disclosed subject matter may be implemented in or across a plurality of processing chips or devices, and storage may be similarly influenced across a plurality of devices. Such devices may include PCs, network servers, and handheld devices.

While the present disclosure has been described with reference to embodiments, it will be apparent to those skilled in the art that various changes and modifications may be made without departing from the spirit and scope of the present disclosure. Therefore, it should be understood that the above embodiments are not limiting, but illustrative.

## Claims

1. A capacitor-less stacked DRAM cell based on a vertical transistor, the capacitor-less stacked DRAM cell comprising:
a first vertical transistor; and
a second vertical transistor,
wherein each of the first vertical transistor and the second vertical transistor includes:
a spacer;
a source disposed on an upper surface of the spacer;
a drain disposed adjacent to a lower portion of a side surface of the spacer;
a channel disposed along an upper surface of the drain, an upper portion of the side surface of the spacer, and an upper surface of the source;
a gate insulator disposed along a side surface and an upper surface of the channel; and
a gate electrode disposed along a side surface and an upper surface of the gate insulator.

2. The capacitor-less stacked DRAM cell of claim 1, wherein the first vertical transistor and the second vertical transistor are disposed to face each other.

3. The capacitor-less stacked DRAM cell of claim 1 or 2, wherein a write word line is connected to the gate electrode of the first vertical transistor,
wherein a write bit line is connected to the source of the first vertical transistor,
wherein a read word line is connected to the source of the second vertical transistor, and
wherein a read bit line is connected to the drain of the second vertical transistor.

4. The capacitor-less stacked DRAM cell of any one of claims 1 to 3, wherein a storage node is disposed between the drain of the first vertical transistor and the gate electrode of the second vertical transistor.

5. The capacitor-less stacked DRAM cell of any one of claims 1 to 4, wherein each of the spacer of the first vertical transistor and the spacer of the second vertical transistor is deposited through ALD or PVD.

6. The capacitor-less stacked DRAM cell of any one of claims 1 to 5, wherein each of the channel of the first vertical transistor and the channel of the second vertical transistor includes an oxide semiconductor.

7. The capacitor-less stacked DRAM cell of claim 6, wherein the oxide semiconductor includes at least one of InO, SnO, ZnO, InZnO, SnZnO, InSnO, SnMgO, InMgO, AlZnO, ZnMgO, InSnZnO, SnGaZnO, AlGaZnO, SnAlZnO, InAlZnO, InGaZnO, or InSnGaZnO.

8. The capacitor-less stacked DRAM cell of any one of claims 1 to 7, wherein a first source being the source of the first vertical transistor and a second source being the source of the second vertical transistor are disposed on the upper surfaces of the spacers of the first vertical transistor and the second vertical transistor such that lower surfaces of the first source and the second source are disposed in positions not facing an upper surface of a first drain being the drain of the first vertical transistor and an upper surface of a second drain being the drain of the second vertical transistor.

9. The capacitor-less stacked DRAM cell of any one of claims 1 to 8, wherein the first vertical transistor includes:
a first spacer;
a first source disposed on an upper surface of the first spacer;
a first drain disposed adjacent to a lower portion of a side surface of the first spacer; and
a first channel disposed along an upper surface of the first drain, an upper portion of the side surface of the first spacer, and an upper surface of the first source, and
wherein the second vertical transistor includes:
a second spacer;
a second source disposed on an upper surface of the second spacer;
a second drain disposed adjacent to a lower portion of a side surface of the second spacer; and
a second channel disposed along an upper surface of the second drain, an upper portion of the side surface of the second spacer, and an upper surface of the second source.

10. The capacitor-less stacked DRAM cell of claim 9, wherein the first drain and the second drain are disposed at the same height with respect to a ground,
wherein the second spacer is configured such that the upper surface thereof is located in a higher position with respect to the ground than the upper surface of the first spacer, and
wherein the second source is disposed in a higher position with respect to the ground than the first source.

11. The capacitor-less stacked DRAM cell of claim 9 or 10, wherein the first vertical transistor further includes:
a first gate insulator disposed along a side surface and an upper surface of the first channel; and
a first gate electrode disposed along a side surface and an upper surface of the first gate insulator, and
wherein the second vertical transistor further includes:
a second gate insulator disposed along a side surface and an upper surface of the second channel; and
a second gate electrode disposed along a side surface and an upper surface of the second gate insulator.

12. A method for manufacturing the capacitor-less stacked DRAM cell based on the vertical transistor of claim 9, the method comprising:
a step of forming the first spacer through dry etching;
a step of forming the second spacer through dry etching;
a step of depositing the first drain on the lower portion of the side surface of the first spacer;
a step of depositing the second drain on the lower portion of the side surface of the second spacer;
a step of depositing the first source on the upper surface of the first spacer;
a step of depositing the second source on the upper surface of the second spacer;
a step of depositing the first channel along the upper portion of the side surface of the first spacer and the upper surface of the first source; and
a step of depositing the second channel along the upper portion of the side surface of the second spacer and the upper surface of the second source.

13. The method of claim 12, wherein the step of depositing the first drain on the lower portion of the side surface of the first spacer includes a step of depositing the first drain on the lower portion of the side surface of the first spacer configured to face the side surface of the second spacer, and
wherein the step of depositing the second drain on the lower portion of the side surface of the second spacer includes a step of depositing the second drain on the lower portion of the side surface of the second spacer configured to face the side surface of the first spacer.

14. The method of claim 12 or 13, wherein the step of forming the second spacer through the dry etching includes a step of forming the second spacer such that the upper surface of the second spacer is located in a higher position with respect to a ground than the upper surface of the first spacer, and
wherein the step of depositing the second source on the upper surface of the second spacer includes a step of depositing the second source such that the second source is disposed in a higher position with respect to the ground than the first source.

15. The method of any one of claims 12 to 14, wherein the step of depositing the first channel includes a step of depositing the first channel along the upper surface of the first source and the upper portion of the side surface of the first spacer configured to face the side surface of the second spacer, and
wherein the step of depositing the second channel includes a step of depositing the second channel along the upper surface of the second source and the upper portion of the side surface of the second spacer configured to face the side surface of the first spacer.
